# EUROPEAN PATENT APPLICATION

(11) **EP 4 604 691 A1**
(43) Date of publication of application: **20.08.2025**
(21) Application number: 25156707.9
(22) Date of filing: 07.02.2025
(51) Int. Cl.: H10D 62/10, H10D 30/47, H10D 30/01, H10D 64/00, H10D 62/85

(54) **SEMICONDUCTOR STRUCTURE WITH PATTERNED DIELECTRIC LAYER BENEATH FIELD PLATES**

(30) Priority: 16.02.2024 US 202463554235 P; 29.01.2025 US 202519040551
(71) Applicant: Finwave Semiconductor, Inc., Belmont MA 02478 (US)
(72) Inventor: Lu, Bin, Fremont, 94555 (US); Pei, Donfei, Waban, 02468 (US); Dipsey, Mark, Arlington, 02474 (US)
(74) Representative: Uexküll & Stolberg

(57) **Abstract**

A new semiconductor structure is disclosed. The semiconductor structure includes patterned dielectric layers disposed between the field plates and the channel layer. These patterned dielectric layers serve to further shape the electric field in the channel layer. This structure is not only applicable to III-nitride semiconductor devices, such as transistors, diodes or any other devices, but also is applicable to other semiconductor devices, such as Si LDMOS, SiC transistors, GaAs transistors.

## Description

This application claims priority to U.S. Provisional Patent Application Serial No. 63/554,235, filed February 16, 2024 and U.S. Patent Application Serial No. 19/040,551, filed January 29, 2025, the disclosures of which are incorporated herein by reference in their entireties.

### FIELD

Embodiments of the present disclosure relate to a semiconductor structure and methods for making a semiconductor structure that utilizes one or more field plates.

### BACKGROUND

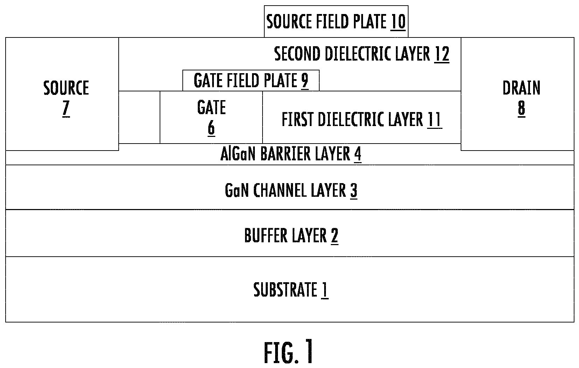

FIG. 1 shows a typical conventional III-Nitride semiconductor transistor which comprises a substrate 1, a buffer layer 2 on top of the substrate, a GaN channel layer 3 on top of the buffer layer and AlGaN barrier layer 4 on top of the channel layer. The substrate 1 is SiC, sapphire, Si or free-standing GaN semiconductors. A nucleation layer exists between the buffer layer 2 and the substrate 1. The barrier layer 4, which may be made from AlGaN, has a wider band-gap than the channel layer 3, which may be made from GaN. Source electrode 7 and drain electrode 8 are disposed on opposite sides of the gate electrode 6 in the length direction. The direction that is orthogonal to the length direction and perpendicular to the page in FIG. 1 is referred to as the width direction. The region in the height or thickness direction between the top of the barrier layer 4 and the top of the gate electrode 6 may be filled with a first dielectric material to form a first dielectric layer 11.

In some embodiments, a gate connected field plate 9 may be disposed on top of the first dielectric layer 11 and electrically connected to the gate electrode 6.

A second dielectric material may be deposited on top of the gate electrode 6 and the gate connected field plate 9. This second dielectric material may be the same as the first dielectric material, or may be a different dielectric material having a different dielectric constant. This second dielectric material forms a second dielectric layer 12. A source connected field plate 10 may be disposed on top of the second dielectric layer 12.

The dielectric layers are typically deposited layered over the entire semiconductor material underneath, without any variations in the length or width directions.

These field plates may serve to shape the electric fields in the channel layer 3. In some embodiments, only one of the two field plates may be utilized.

Note that the region in the height direction between the gate connected field plate 9 and the barrier layer 4 is homogeneous, and comprises only the first dielectric material. Also note that the region in the height direction between the source connected field plate 10 and the barrier layer 4 may be stratified in the height direction, but is homogenous in the length and width directions. In other words, at a given height, the dielectric material is uniform in the length and width directions.

Therefore, the shaping of the electric field is only tunable by varying the first and second dielectric materials, and/or by modifying the sizes and shapes of the two field plates.

Thus, it may be beneficial if there were new semiconductor structures that allowed greater ability to shape the electrical field in the channel layer.

### SUMMARY

A new semiconductor structure is disclosed. The semiconductor structure includes patterned dielectric layers disposed between the field plates and the channel layer. These patterned dielectric layers serve to further shape the electric field in the channel layer. This structure is not only applicable to III-nitride semiconductor devices, such as transistors, diodes or any other devices, but also is applicable to other semiconductor devices, such as Si LDMOS, SiC transistors, GaAs transistors.

According to one embodiment, a semiconductor structure for use in a III-Nitride (III-N) semiconductor device is disclosed. The semiconductor structure comprises a channel layer; a barrier layer located on the channel layer in a height direction, wherein electrons are formed at an interface between the channel layer and the barrier layer; a source electrode and a drain electrode; a field plate disposed between the source electrode and the drain electrode in a length direction; and a patterned dielectric layer disposed in a region between the field plate and the barrier layer in the height direction, wherein the patterned dielectric layer is patterned in the length direction and a width direction. In some embodiments, the patterned dielectric layer comprises a first dielectric material having a plurality of voids that are filled with a second dielectric material having a different dielectric constant. In certain embodiments, a density of the plurality of voids is non uniform in the length direction. In some embodiments, the region also comprises a uniform layer of dielectric material. In certain embodiments, the uniform layer of dielectric material is disposed between the barrier layer and the patterned dielectric layer. In certain embodiments, the uniform layer of dielectric material is disposed between the field plate and the patterned dielectric layer.

In some embodiments, the region also comprises at least two uniform layers of dielectric material, wherein a first uniform layer is disposed between the field plate and the patterned dielectric layer and a second uniform layer is disposed between the patterned dielectric layer and the barrier layer. In certain embodiments, the first uniform layer and the second uniform layer comprise different dielectric materials. In certain embodiments, the first uniform layer and the second uniform layer comprise a same dielectric material.

In some embodiments, a gate electrode is disposed between the source electrode and the drain electrode in the length direction; wherein the field plate is connected to the gate electrode. In some embodiments, the field plate is connected to the source electrode. In some embodiments, the patterned dielectric layer extends beyond the field plate in the length direction.

In some embodiments, a second field plate is disposed between the source electrode and the drain electrode in the length direction; and a second patterned dielectric layer is disposed in a region between the second field plate and the barrier layer in the height direction. In certain embodiments, the second patterned dielectric layer is a same configuration as the patterned dielectric layer. In certain embodiments, a configuration of the second patterned dielectric layer is different from a configuration of the patterned dielectric layer. In certain embodiments, at least a third field plate is disposed between the source electrode and the drain electrode in the length direction; and a third patterned dielectric layer is disposed in a region between at least the third field plate and the barrier layer in the height direction.

### BRIEF DESCRIPTION OF THE FIGURES

For a better understanding of the present disclosure, reference is made to the accompanying drawings, which are incorporated herein by reference and in which:
FIG. 1 shows the layout of a conventional III-Nitride transistor according to the prior art;
FIGs. 2A-2B show an improved III-Nitride transistor that includes a patterned dielectric layer;
FIGs. 3A-3D shows top views of variations of the III-Nitride transistor of FIG. 2A;
FIGs. 4A-4D shows cross-sectional view of variations of the III-Nitride transistor of FIG. 2B; and
FIG. 5 is a flowchart showing the sequence used to fabricate the III-Nitride transistor shown in any of the figures.

### DETAILED DESCRIPTION

This disclosure describes a semiconductor structure with patterned dielectric layers.

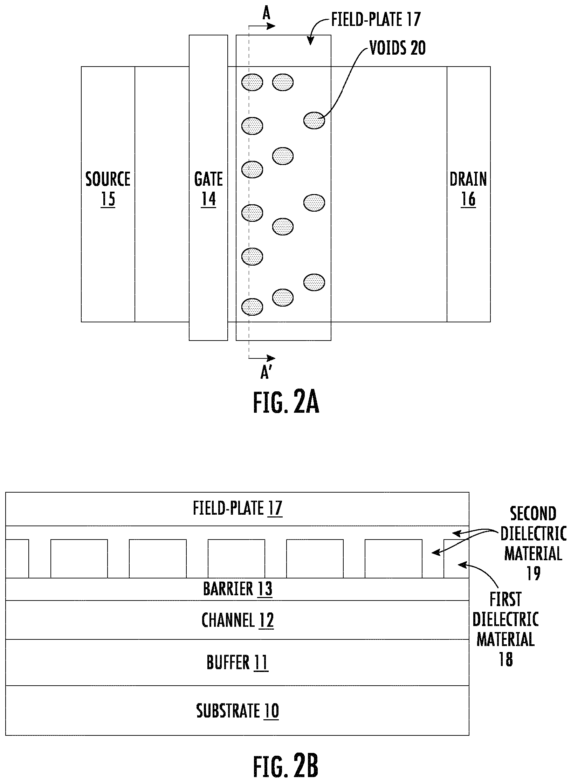

According to one embodiment, shown in FIGs. 2A-2B, the semiconductor structure includes a substrate 10, a buffer layer 11, a channel layer 12, and a barrier layer 13. These figures represent a transistor; however, this disclosure also applies to diodes. FIG. 2A represents a top view of the transistor structure, while FIG. 2B represents a cross-sectional view along line A-A'. In some embodiments, a nucleation layer (not shown) may be disposed between the substrate 10 and the buffer layer 11.

The substrate 10 may be SiC, sapphire, Si, free-standing GaN or any other substrate including multiple layers including polycrystalline AlN. A nucleation layer may be disposed between the buffer layer 11 and surface of the substrate 10. The nucleation layer may include AlN.

A buffer layer 11 is formed over the nucleation layer. The buffer layer 11 may have a thickness between 0.5 nm and several microns, although other thicknesses are within the scope of the disclosure. The buffer layer 11 may comprise III-nitride semiconductors including GaN, AlGaN, InGaN, InAlN, InAlGaN and AlN.

A channel layer 12 is formed over the buffer layer 11. The channel layer 12 comprises a semiconductor material selected from AlGaN, InGaN, GaN, or any other suitable semiconductor material or combination of materials.

Carriers, which may be free electrons, exist in the channel layer 12 to conduct electrical current between the drain electrode 16 and the source electrode 15.

The channel layer 12 may comprise a single layer such as a GaN layer, or multiple layers. In one example, the channel layer 12 comprises a back-barrier structure, such as a GaN layer over an AlGaN layer (GaN/AlGaN) or a GaN layer over an InGaN layer and another GaN layer (GaN/InGaN/GaN). In another example, the channel layer 12 has a superlattice structure formed by repeating a bilayer structure of AlGaN/GaN or AlN/GaN. The thickness of the channel layer 12 may be greater than 5 nm, such as between 50 nm and 400 nm, although other thicknesses may be used.

A barrier layer 13 is formed over the channel layer 12. The barrier layer 13 may be made of III-nitride semiconductors selected from AlGaN, InAlN, AlN, AlScN or InAlGaN with a non-zero aluminum content. The barrier layer 13 may be un-doped, or doped with Si or other impurities. The barrier layer 13 has a wider band-gap than the channel layer 12. The barrier layer 13 may be between 0.2 nm and 30 nm. A thin barrier layer, such as less than 10 nm, may be utilized. The barrier layer 13 may contain sub-layers. For example, a sub-layer of AlN may be adjacent to the channel layer 12 and a AlGaN or InAlN sublayer may be disposed on top of the AlN sublayer.

The top of the semiconductor structure includes a gate electrode 14, a source electrode 15 and a drain electrode 16.

A field plate 17 may also be included in the transistor structure. Although FIGs. 2A-2B only show one field plate 17, it is understood that in some embodiments, there may be two field plates.

Between the field plate 17 and the barrier layer 13 is dielectric material. However, unlike FIG. 1, the dielectric material is not uniform in the length and width directions. For example, in this embodiment, there is a first dielectric material 18 that is disposed between the barrier layer 13 and a height below the field plate 17. This first dielectric material may be patterned to create voids 20 or holes therein. These voids 20 are then filled with a second dielectric material 19, having a different dielectric constant than the first dielectric material. The dielectric constant of the second dielectric material 19 may be higher or lower than the dielectric constant of the first dielectric material 18. This combination forms a patterned dielectric layer. This second dielectric material 19 may also form a uniform layer above the first dielectric material, as shown in FIG. 2B.

The dielectric materials may be any suitable dielectric, including SiO₂, SiN, HfOz or another suitable material having a dielectric constant between 1 and 200 or higher.

In some embodiments, the voids 20 may be circular or oval in shape, as shown in FIG. 2A, with a diameter between 10 nm and 500 nm.

Additionally, as shown in FIG. 2A, the density of the voids 20 underneath the field plate 17 may be non-uniform in either the width or length direction. In one embodiment, the density of the void 20 decreases along the length direction moving from the gate electrode 14 to the drain electrode 16.

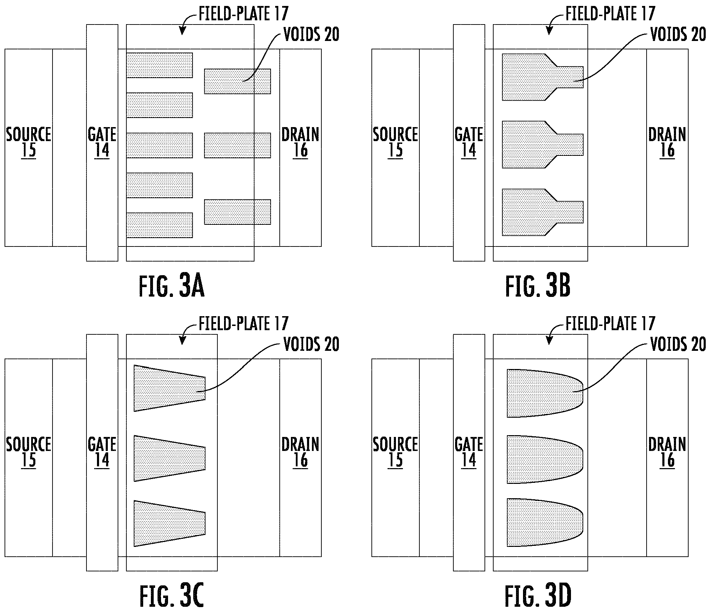

Further, it is understood that the voids 20 need not be circular or oval. FIGs. 3A-3D shows other shapes for the voids 20 that may be used. FIG. 3A shows voids 20 in the form of rectangles. FIG. 3B shows voids 20 that comprise larger rectangles tapered to smaller rectangles. FIG. 3C shows voids 20 in the form of trapezoids. FIG. 3D shows voids 20 with both straight and curved walls. Note that in some embodiments, like that shown in FIGs. 2A, 3B-3D, the voids 20 are formed only in the region beneath the field plate 17. However, in other embodiments, such as that shown in FIG. 3A, the voids 20 may extend beyond the field plate 17 in the length direction.

Each of the transistors shown in FIGs. 2A-2B and 3A-3D may be either normally-on transistors with electrons in the channel layer 12 underneath the gate electrode 14 connecting the source and drain when the gate electrode 14 is not biased, or normally-off transistors with the electrons absent from the channel layer 12 underneath the gate when the gate electrode 14 is not biased.

Note that FIG. 2B shows a cross-sectional view of the patterned dielectric layer beneath the field plate 17. While FIG. 2B shows a patterned layer with the second dielectric material filling voids 20 in the first dielectric layer and a uniform layer of the second dielectric layer located above the patterned layer, other embodiments are also possible. For example, the uniform layer above the patterned layer may comprise the first dielectric material 18.

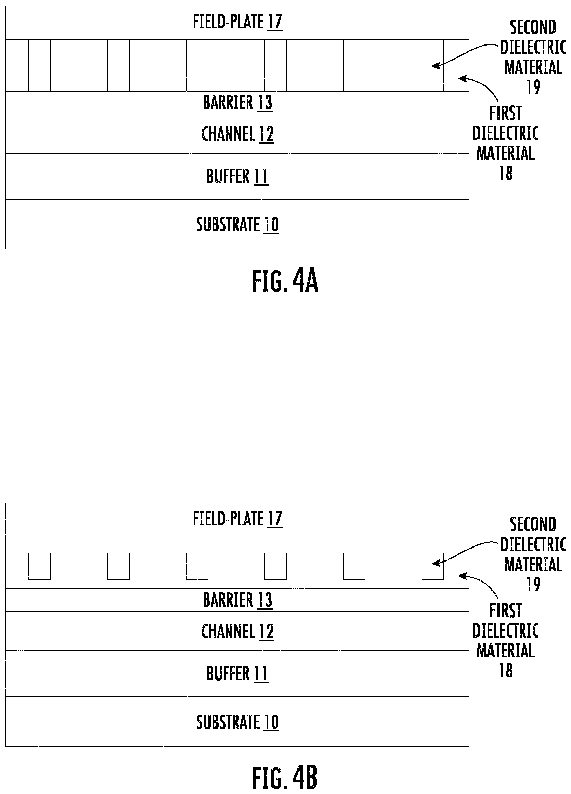

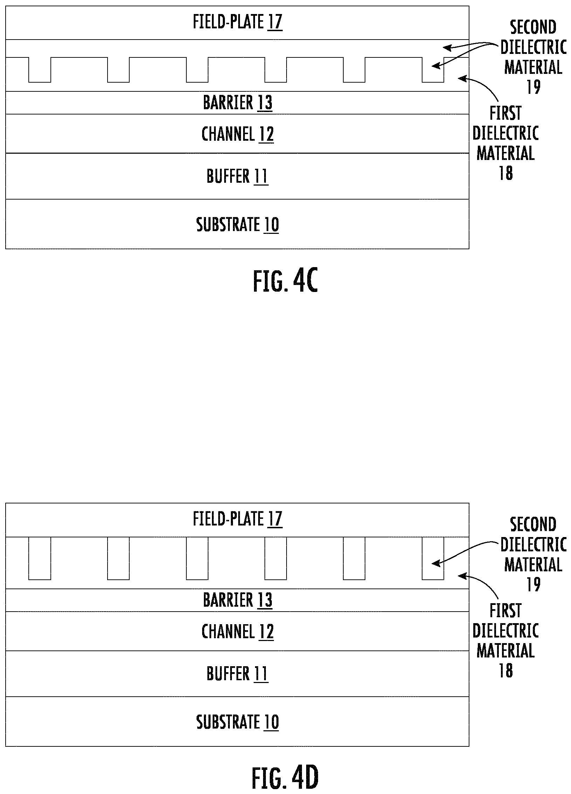

FIG. 4A-4D show some other embodiments. In FIG. 4A, the patterned layer extends all the way from the barrier layer 13 to the field plate 17. In FIG. 4B, the patterned layer is sandwiched between two uniform layers, wherein the two uniform layers comprise the same dielectric material. While FIG. 4B shows that the two uniform layers are both the first dielectric material 18, it is also possible that the two uniform layers are both the second dielectric material 19. In FIG. 4C, the patterned layer is sandwiched between two uniform layers, wherein the two uniform layers comprise different dielectric materials. While FIG. 4C shows that the top uniform layer as being the second dielectric material 19 and the bottom uniform layer as being the first dielectric material 18, it is also possible that the top uniform layer is the first dielectric material 18 and the bottom uniform layer is the second dielectric material 19. Finally, FIG. 4D shows the uniform layer as being beneath the patterned layer, so as to be closer to the barrier layer 13. While FIG. 4D shows the uniform layer as being the first dielectric material 18, it is understood that the uniform layer may be either the first dielectric material 18 or the second dielectric material 19.

Note that the patterned dielectric materials shown in FIGs. 2B, 4A-4D may be disposed beneath a gate-connected field plate, a source-connected field plate or both field plates. In the case where two field plates are used, the configuration of the patterned dielectric layer beneath each field plate may be the same or may be different. Furthermore, in some embodiments, there may be more than two field plates, wherein two or more of the field plates are gate-connected field plates and/or two or more of the field plates are source-connected field plates.

Also note that while the figures show a first dielectric material 18 and a second dielectric material 19, in other embodiments, three or more dielectric materials may be used.

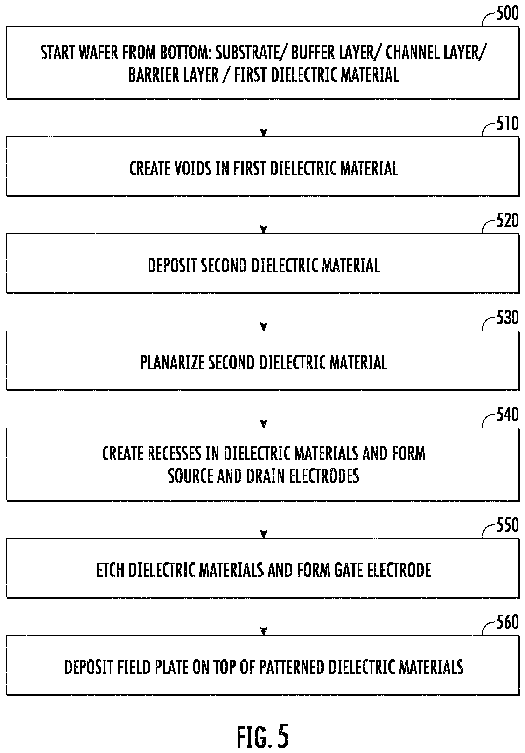

FIG. 5 shows a fabrication sequence that may be used to create the semiconductor structure of FIGs. 2A-2B. First, as shown in Box 500, the buffer layer 11, channel layer 12, the barrier layer 13 and the first dielectric material 18 are deposited on the substrate 10. The first dielectric material 18 may be deposited using PECVD, ALD, PVD or any other suitable method. Then, as shown in Box 510, voids 20 are created in the first dielectric material 18. These voids 20 may be created using a patterned etching process. These voids 20 may be located in the regions where the one or more field plates 17 will be deposited or may extend beyond those regions. For the embodiments, shown in FIGs. 2B and 4A, the first dielectric material 18 etched until the barrier layer 13 is reached. In the embodiments shown in FIGs. 4B-4D, the etching process terminates before the barrier layer 13 is reached. As shown in Box 520, the second dielectric material 19 is then deposited. The second dielectric material 19 may be deposited using PECVD, ALD, PVD or any other suitable method. Next, as shown in Box 530, the second dielectric material 19 is planarized. This may be done using an etching process or by the use of CMP (chemical mechanical planarization). For the embodiments shown in FIGs. 4A, 4B and 4D, planarization continues until the first dielectric material 18 is reached. For the embodiments shown in FIGs. 2B and 4C, planarization stops before the first dielectric material 18 is reached, leaving a uniform layer of the second dielectric material 19 on top of the patterned layer. In some embodiments, like that shown in FIG. 4B, a second deposition of the first dielectric material 18 may be performed. Then, as shown in Box 540, recesses are made in the dielectric materials and the source electrode 15 and drain electrode 16 are deposited. Next, as shown in Box 550, the dielectric materials are etched and the gate electrode 14 is deposited. For the fabrication of a diode, this step may be omitted. Finally, as shown in Box 560, one or more field plates 17 are deposited on top of the dielectric materials.

There are variations of this fabrication sequence. For example, the order in which the gate electrode 14 and the source and drain electrodes are formed may be changed. Further, additional process steps, which are not shown here, include depositing additional dielectric layers, forming of field plates and interconnections.

Note that while the disclosure is described using a transistor, the patterned dielectric materials are applicable to any semiconductor structure that utilizes field plates, such as diodes and other devices. In each of these semiconductor structures, there is a source electrode and a drain electrode that are spaced apart in a length direction. A channel layer is disposed between these two electrodes. The field plate is disposed above the channel layer and is separated from the channel layer by the patterned dielectric materials and optionally a barrier layer.

Furthermore, the disclosure is not limited to III-Nitride structures. This is also applicable to silicon based MOSFETs (metal-oxide-semiconductor field-effect-transistor), LDMOS (laterally-diffused MOS), silicon carbide transistors, and GaAs devices.

The present disclosure is not to be limited in scope by the specific embodiments described herein. Indeed, other various embodiments of and modifications to the present disclosure, in addition to those described herein, will be apparent to those of ordinary skill in the art from the foregoing description and accompanying drawings. Thus, such other embodiments and modifications are intended to fall within the scope of the present disclosure. Furthermore, although the present disclosure has been described herein in the context of a particular implementation in a particular environment for a particular purpose, those of ordinary skill in the art will recognize that its usefulness is not limited thereto and that the present disclosure may be beneficially implemented in any number of environments for any number of purposes. Accordingly, the claims set forth below should be construed in view of the full breadth and spirit of the present disclosure as described herein.

## Claims

1. A semiconductor structure for use in a III-Nitride (III-N) semiconductor device, comprising:
a channel layer;
a barrier layer located on the channel layer in a height direction, wherein electrons are formed at an interface between the channel layer and the barrier layer;
a source electrode and a drain electrode;
a field plate disposed between the source electrode and the drain electrode in a length direction; and
a patterned dielectric layer disposed in a region between the field plate and the barrier layer in the height direction, wherein the patterned dielectric layer is patterned in the length direction and a width direction.

2. The semiconductor structure of claim 1, wherein the patterned dielectric layer comprises a first dielectric material having a plurality of voids that are filled with a second dielectric material having a different dielectric constant.

3. The semiconductor structure of claim 2, wherein a density of the plurality of voids is non uniform in the length direction.

4. The semiconductor structure of claim 1, wherein the region also comprises a uniform layer of dielectric material.

5. The semiconductor structure of claim 4, wherein the uniform layer of dielectric material is disposed between the barrier layer and the patterned dielectric layer.

6. The semiconductor structure of claim 4, wherein the uniform layer of dielectric material is disposed between the field plate and the patterned dielectric layer.

7. The semiconductor structure of claim 1, wherein the region also comprises at least two uniform layers of dielectric material, wherein a first uniform layer is disposed between the field plate and the patterned dielectric layer and a second uniform layer is disposed between the patterned dielectric layer and the barrier layer.

8. The semiconductor structure of claim 7, wherein the first uniform layer and the second uniform layer comprise different dielectric materials.

9. The semiconductor structure of claim 7, wherein the first uniform layer and the second uniform layer comprise a same dielectric material.

10. The semiconductor structure of claim 1, further comprising a gate electrode disposed between the source electrode and the drain electrode in the length direction; wherein the field plate is connected to the gate electrode.

11. The semiconductor structure of claim 1, wherein the field plate is connected to the source electrode.

12. The semiconductor structure of claim 1, wherein the patterned dielectric layer extends beyond the field plate in the length direction.

13. The semiconductor structure of claim 1, further comprising:
a second field plate disposed between the source electrode and the drain electrode in the length direction; and
a second patterned dielectric layer disposed in a region between the second field plate and the barrier layer in the height direction.

14. The semiconductor structure of claim 13, wherein the second patterned dielectric layer is a same configuration as the patterned dielectric layer.

15. The semiconductor structure of claim 13, wherein a configuration of the second patterned dielectric layer is different from a configuration of the patterned dielectric layer.
